# EUROPÄISCHE PATENTSCHRIFT

(11) **EP 1 367 145 B1**
(45) Veröffentlichungstag und Bekanntmachung des Hinweises auf die Patenterteilung: **17.05.2006**
(21) Anmeldenummer: 03011737.8
(22) Anmeldetag: 23.05.2003
(51) Int. Cl.: C23C 16/54, C23C 16/04

(54) **Vorrichtung für CVD-Behandlungen**
CVD apparatus
Dispositif de dépôt chimique en phase vapeur

(30) Priorität: 27.06.2002 DE 10228898; 24.05.2002 DE 10223288
(43) Veröffentlichungstag der Anmeldung: 03.12.2003
(73) Patentinhaber: Schott AG, 55122 Mainz (DE)
(72) Erfinder: Arnold, Gregor, 55294 Bodenheim (DE); Lüttringhaus-Henkel, Andreas, 64289 Darmstadt (DE); Behle, Stephan, Dr., 55278 Hahnheim (DE); Bicker, Matthias, Dr., 55126 Mainz (DE)
(74) Vertreter: Blumbach - Zinngrebe

(56) Entgegenhaltungen:
- WO-A-01/31680
- WO-A-99/49991
- US-A- 5 324 361
- PATENT ABSTRACTS OF JAPAN vol. 006, no. 218 (E-139), 2. November 1982 (1982-11-02) & JP 57 121246 A (HITACHI SEISAKUSHO KK), 28. Juli 1982 (1982-07-28)

## Beschreibung

Die Erfindung betrifft eine Vorrichtung für CVD-Behandlungen, insbesondere eine Vorrichtung für CVD-Behandlungen mit CVD-Reaktoren.

Kunststoffhohlbehälter, wie etwa Plastikflaschen weisen zumeist eine für den gedachten Verwendungszweck nicht ausreichende Barrierewirkung für Gase auf. Beispielsweise können Gase wie Kohlendioxid aus dem Behälter hinaus- oder in diesen hineindiffundieren. Dieser Effekt ist zumeist unerwünscht. Unter anderem führt dieser Effekt zu einer Verkürzung der Haltbarkeit von in diesen Behältern gelagerten Getränken.

Um diese Nachteile bei Kunststoffgefäßen mit ihren ansonsten vielfältigen Vorzügen, wie niedriges Gewicht und Stabilität gegenüber mechanischer Schockeinwirkung zu beseitigen, sind Techniken zum Aufbringen von Barriereschichten, beziehungsweise Diffusionssperrschichten entwickelt worden.

Eine besonders effektive und kostengünstige Technologie für das Aufbringen solcher Schichten ist die chemische Dampfphasenabscheidung (CVD). Bei den CVD-Verfahren geschieht die Abscheidung einer Schicht über ein reaktives chemisches Gasgemisch, welche die zu beschichtende Oberfläche umgibt.

Aus Gemischen verschiedener Gase läßt sich so eine nahezu unbegrenzte Vielfalt möglicher Schichten erzeugen. Als Diffusionsbarrieren haben sich dabei unter anderem Oxidschichten, wie etwa SiO₂-Schichten bewährt.

Ein chemisch reaktives Gasgemisch kann für die CVD-Beschichtung thermisch oder durch Ionisation der Prozeßgase durch Eintrag von Energie erzeugt werden. Da Kunststoffe in der Regel thermisch nicht ausreichend stabil sind oder niedrige Erweichungspunkte aufweisen, ist für die Beschichtung von Kunstoffoberflächen CVD-Beschichtung unter Temperatureinwirkung ungeeignet. Hier bietet sich jedoch die Möglichkeit der Plasmaunterstützten CVD-Beschichtung (PECVD) an. Da auch hier durch das Plasma eine Erwärmung der zu beschichtenden Oberfläche auftritt ist insbesondere die Plasmaimpuls-induzierte CVD-Beschichtung (PICVD) geeignet.

Um ein solches Verfahren industriell einsetzen zu können, werden aufgrund der Prozeßzeiten eine Vielzahl von Kammern benötigt, in denen gleichzeitig oder zeitlich versetzt eine Beschichtung durchgeführt wird. Da PICVD-Beschichtungen unter Niederdruckbedingungen durchgeführt werden, ergibt sich dabei das Problem, die zu beschichtenden Werkstücke, wie etwa Kunststoffhohlkörper in die Beschichtungsbereiche zu schleusen und diese zu evakuieren. Dazu wird der Beschichtungsreaktor von oben geöffnet und bestückt, wie beispielsweise in der WO 01/31680 A1 offenbart. Die Bewegungsführung erfolgt üblicherweise über Steuerkurven. Die Bestückung dieser Reaktoren ist jedoch kompliziert und zeitaufwendig.

Darüber hinaus ist es bei Hohlkörpern oft sinnvoll, entweder nur die Innenwand oder Außenwand zu beschichten, oder auf Innen- und Außenwand jeweils unterschiedliche Beschichtungen aufzubringen, so dass der Innenraum des Hohlkörpers und die Umgebung mit unterschiedlichen Prozeßgasen aufgefüllt werden muß.

Es ist daher die Aufgabe der vorliegenden Erfindung, die Ein-und Ausschleusung von Werkstücken für deren CVD-Behandlung in Reaktoren zu vereinfachen. Diese Aufgabe wird bereits in höchst überraschend einfacher Weise durch eine Vorrichtung zum CVD-Behandeln von Werkstücken gemäß Anspruch 1, sowie ein Verfahren zum CVD-Behandeln von Werkstücken gemäß Anspruch 15 gelöst. Vorteilhafte Weiterbildungen sind Gegenstand der jeweiligen Unteransprüche.

Demgemäß umfaßt eine erfindungsgemäße Vorrichtung eine Transporteinrichtung und zumindest einen auf der Transporteinrichtung befestigten Reaktor, in welchem die CVD-Behandlung vorgenommen wird, wobei die Vorrichtung zumindest eine mechanische Steuerkurve und der Reaktor eine Einrichtung zum Öffnen und Schließen aufweisen, welche mit der zumindest einen Steuerkurve betätigt wird.

Das CVD-Behandeln kann dabei außer dem Beschichten auch eine andere Oberflächenbehandlung, wie etwa die Oberflächenaktivierung in der Dampfphase umfassen.

In einfacher Weise läßt sich dabei das Öffnen und Schließen des Reaktors automatisieren, wenn die Einrichtung zum Öffnen und Schließen des Reaktors durch Vorbeibewegen des Reaktors an der Steuerkurve betätigt wird.

Bevorzugt umfaßt der Reaktor einen ersten und einen zweiten Teil, wobei die Teile eine Reaktorkammer umschließen.

Dazu kann der erste Teil mit der Transporteinrichtung und der zweite Teil mit der Einrichtung zum Öffnen und Schließen verbunden sein. Die zweiteilige Ausführung der Reaktoren erlaubt eine weite Öffnung zur Reaktorkammer und damit ein leichtes Einsetzen und Herausnehmen der zu beschichtenden Werkstücke.

Dies läßt sich insbesondere dadurch erreichen, daß die Steuerkurve so angeordnet ist, daß die Einrichtung zum Öffnen und Schließen den zweiten Teil beim Öffnen zunächst in einer ersten Bewegung vom ersten Teil weg und dann in einer zur ersten Bewegung im wesentlichen senkrechten zweiten Bewegung am ersten Teil vorbei bewegt wird.

Eine besonders einfache Dichtung der beiden Teile läßt sich mit einer ebene Dichtfläche zwischen erstem und zweiten Teil erreichen.

Mit Vorteil können Rundläufer- und/oder Langläufervorrichtungen für den Transport der Reaktoren, beziehungsweise der darin zu beschichtenden Werkstücke benutzt werden.

Der Kontakt der Einrichtung zum Öffnen und Schließen mit der mechanischen Steuerkurve kann beispielsweise über an der Einrichtung befestigte Kurvenrollen hergestellt werden, so daß die Kurvenrollen auf der Steuerkurve entlangrollen. Auf diese Weise werden Reibungskräfte beim Vorbeibewegen des Reaktors an der Steuerkurve vermieden.

Der Reaktor kann ein für elektromagnetische Wellen, insbesondere für Mikrowellen durchlässiges Fenster aufweisen. Dadurch können die elektromagnetischen Wellen für die Plasmaerzeugung außerhalb des Reaktors erzeugt werden, so daß auf einen aufwendigen mit dem Reaktor mitgeführten Feldapplikator verzichtet werden kann.

Besonders vorteilhaft ist es auch, wenn der Reaktor eine Einrichtung zum Evakuieren aufweist. Dadurch kann die Reaktorkammer separat abgepumpt werden und es ist nicht notwendig, die gesamte Vorrichtung zu evakuieren, um den für das Plasma erforderlichen Niederdruck bereitzustellen. Außerdem kann eine Einrichtung zum Einspeisen eines Prozeßgases vorhanden sein, um die Reaktorkammer mit dem Prozeßgas zu befüllen.

Insbesondere kann der Reaktor mit einer Gaslanze zum Einspeisen eines Prozeßgases ausgestattet sein. Mit einer Gaslanze lassen sich beispielsweise die Innenräume von Kunststoffhohlkörpern schnell mit einem Prozeßgas beschicken.

Um die Werkstücke in den Reaktor und aus diesem heraus zu befördern, kann die Vorrichtung zum CVD-Behandeln vorteilhaft mit Zuteilrädern ausgestattet sein. Diese ermöglichen auf einfache Weise einen kontinuierlichen Produktionsprozeß ohne eine aufwendige Mechanik.

Im Rahmen der Erfindung liegt es auch, ein Verfahren zum CVD-Behandeln von Werkstücken in einem auf einer Transporteinrichtung befestigten Reaktor anzugeben, welches sich durch einen besonders einfachen Ein- und Ausschleusungsvorgang auszeichnet. Erfindungsgemäß umfaßt das Verfahren dazu die Schritte des Einfügens des Werkstücks in den Reaktor, des Evakuierens zumindest eines Bereiches der Reaktorkammer, des Einfüllens eines Prozeßgases, des Erzeugens eines Plasmas und des Herausnehmens des Werkstücks, wobei das Öffnen und/oder Schließen des Reaktors mittels einer daran befestigten Einrichtung durch Vorbeibewegen an einer mechanischen Steuerkurve bewirkt wird.

Vorteilhaft kann dabei der Schritt des Erzeugens eines Plasmas den Schritt des Einstrahlens von elektromagnetischen Wellen umfassen. Insbesondere ist das Einstrahlen von gepulsten elektromagnetischen Wellen günstig, womit durch das gepulste Plasma in der Umgebung der zu beschichtenden Flächen des Werkstücks eine PICVD-Behandlung der Werkstücke erzielt wird. Durch Einstrahlung von Mikrowellen kann außerdem eine hohe Strahlungsleistung vom Plasma absorbiert werden.

Um eine große Öffnung der Reaktorkammer für das Ein- und Ausschleusen zu erreichen, kann der Reaktor zumindest zwei Teile umfassen, welche beim Schließen und/oder Öffnen des Reaktors aneinander vorbei und aufeinander zu bewegt werden.

Ein Einführen und Herausführen der Werkstücke mittels Zuteilräder ist für einen kontinuierlichen Beschichtungsablauf von Vorteil.

Das erfindungsgemäße Verfahren kann auch für die CVD-Behandlung von Hohlkörpern, wie etwa Flaschen eingesetzt werden. Zur Beschichtung von Hohlkörpern kann der Schritt des Evakuierens zumindest eines Teils der Reaktorkammer den Schritt des Evakuierens des vom Hohlkörper umschlossenen Volumens umfassen. Insbesondere für Innenbeschichtungen kann dazu ein Prozeßgas in das vom Hohlkörper umschlossene Volumen eingefüllt werden. Der Verfahrensschritt des Erzeugens eines Plasmas in dem vom Hohlkörper umschlossenen Volumen sorgt schließlich für die Innenbehandlung der Hohlkörper.

Die Erfindung wird im folgenden anhand bevorzugter Ausführungsformen und unter Bezugnahme auf die beigefügten Zeichnungen näher erläutert Dabei beziehen sich gleiche Bezugszeichen auf gleiche oder ähnliche Teile.

Es zeigen:
- Fig. 1: eine teilweise Querschnittsansicht durch eine Ausführungsform eines Reaktors,
- Fig. 2: eine Aufsicht auf den Reaktor, und
- Fig. 3A bis 3D: Illustrationen verschiedener Phasen des Ein- und Ausschleusens von Werkstücken in den Reaktor.

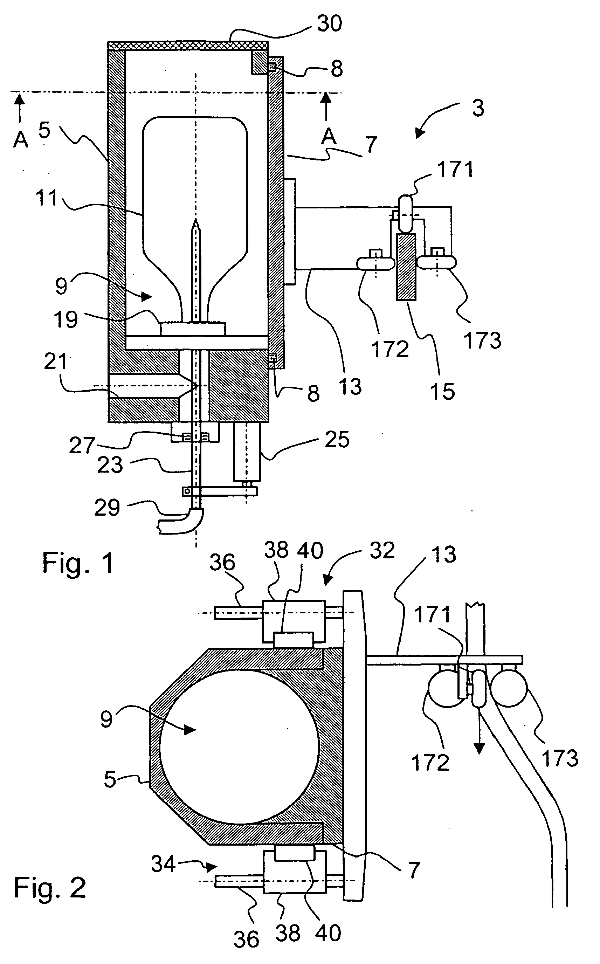

In Fig. 1 ist eine teilweise Querschnittsansicht durch eine Ausführungsform eines Reaktors für eine erfindungsgemäße Vorrichtung zur CVD-Behandlung von Werkstücken dargestellt. Dieser Reaktor ist speziell für die Behandlung von Hohlkörpern, insbesondere von Kunststoffhohlkörpern, wie etwa Kunststoffflaschen ausgelegt. Der im ganzen mit 3 bezeichnete Reaktor umfaßt zwei Teile 5 und 7, welche eine Reaktorkammer 9 umschließen. Die Reaktorkammer ist mittels einer Dichtung 8 zwischen den beiden Teilen 5 und 7 gegen die Umgebung abgedichtet. Die Dichtfläche zwischen den beiden Teilen 5 und 7 ist dabei eine ebene Fläche.
Am Teil 7 befestigt ist eine Einrichtung 13 zum Öffnen und Schließen des Reaktors. Diese Einrichtung 13 umfaßt einen Ausleger, an welchem Kurvenrollen 171, 172, 173 befestigt sind, welche eine Steuerkurve 15, die an der Vorrichtung zum CVD-Behandeln angebacht ist, umgreifen. Dadurch können die Kurvenrollen dem Verlauf der Steuerkurve 15 folgend sowohl eine Bewegung des zweiten Teils 7 vom ersten weg, als auch senkrecht dazu an diesem vorbei vermitteln.

Eine Aufnahme 19 dient zur Fixierung der zu beschichtenden Kunststofflasche 11 und dichtet den Innenraum der Flasche 11 zum Restvolumen der Reaktorkammer 9 hin ab.

Im ersten Teil des Reaktors befindet sich ein Kanal 21, welcher an eine Pumpvorrichtung angeschlossen ist und als Einrichtung zum Evakuieren der Reaktorkammer dient. Beispielsweise kann der Kanal im Falle einer Rundläufervorrichtung über eine im Zentrum der Rundläufervorrichtung befindliche Vakuumdrehdurchführung an eine Vakuumpumpe angeschlossen sein.

Mit dieser Ausführungsform der Vorrichtung zum CVD-Beschichten können Kunststoffhohlkörper sowohl außen, als auch an deren Innenwänden beschichtet werden. Dazu befindet sich am Reaktor noch eine Gaslanze 23, welche ein geeignetes Prozeßgas in den Innenraum der Flasche leiten kann. Die Gaslanze 23 ist an einer Hubvorrichtung 25 befestigt, so daß die Lanze in die Flasche hineinbewegt werden kann, wenn die Flasche in der Aufnahme 19 befestigt ist und vor dem Herausnehmen der Flasche wieder aus dem Innenraum der Flasche herausgefahren werden kann. Die Gaslanze kann dazu pneumatisch oder ebenfalls über eine Steuerkurve angetrieben werden. Mit einer Dichtung 27 wird der Zuführungskanal 29 gegenüber der Umgebung abgedichtet. Die Dichtung 27 kann dazu als Radial- oder Axialdichtung ausgeführt sein. Die Gaslanze ist über einen Anschlußstutzen 29 mit einer Gaszuführung verbunden.

Nachdem die Reaktorkammer evakuiert und die Prozeßgase in die Kammer eingelassen wurden, wird mittels Einwirkung von Mikrowellen in der Kammer ein Plasma erzeugt. Die Gaszusammensetzung kann außerhalb und innerhalb der Flasche, beziehungsweise des Kunststoffhohlkörpers unterschiedlich sein. Beispielsweise kann die Reaktorkammer weitgehend evakuiert sein, so daß sich in dieser nur noch das verbleibende Restgas befindet. Im Innenraum der Flasche, welcher durch die Flaschenaufnahme gegenüber dem Außenraum abgedichtet ist, kann hingegen über die Gaslanze das Prozeßgas eingelassen werden. Auf diese Weise kommt es unter Einwirkung von Mikrowellen nur zu einer Plasmabildung im Inneren der Flasche, so daß auf diese Weise nur eine Innenbeschichtung vorgenommen wird.

Insbesondere ist es möglich, bei hinreichend stabilen Flaschen auch nur den Innenraum zu evakuieren, welcher dann anschließend über die Gaslanze wieder mit einem Prozeßgas befüllt wird. Die außerhalb der Flasche in der Reaktorkammer vorhandene hohe Gasdichte verhindert, daß die eingestrahlten Mikrowellen in diesem Bereich ein Plasma erzeugen. Dadurch wird nur ein Plasma im Innenraum der Flasche erzeugt, was ebnfalls zu einer Innenbeschichtung oder Innenbehandlung der Flasche führt. Der in Fig. 1 gezeigte Reaktor ist für diesen Betriebsmodus ausgelegt, wenn der Kanal 21 über die Aufnahme nur mit der Flaschenöffnung in Verbindung steht.

Die Mikrowellen zur Erzeugung des Plasmas können beispielsweise über ein für Mikrowellen transparentes Fenster 30 eingekoppelt werden. Dies ermöglicht eine Anordnung eines Feldapplikators außerhalb des Reaktors, der somit nicht mit der Kammer mitgeführt werden muß, was die Konstruktion der Vorrichtung zum CVD-Beschichten erheblich vereinfacht.

In Fig. 2 ist eine Aufsicht auf die Reaktorkammer entlang der in Fig. 1 gezeigten Querschnittslinie A-A abgebildet. Wie anhand von Fig. 2 erkennbar ist, umschließen die beiden Teile 5 und 7 eine im Querschnitt kreisförmige Reaktorkammer 9.

Die beiden Teile sind außerdem mittels zweier im ganzen mit 34, beziehungsweise 36 bezeichneten Führungen beweglich miteinander verbunden. Die Führungen 34 und 36 umfassen dabei jeweils fest mit dem Teil 7 verbundene Stifte 36, welche in einem Block 38 geführt werden, so daß eine Bewegung des Teils 7 entlang der Längsachse der Stifte relativ zu Teil 5 ermöglicht wird. Außerdem werden die Blöcke 38 in Führungsschienen 40 geführt, so daß Teil 7 auch in einer zu den Längsachsen der Stifte 36 senkrechte Bewegung von Teil 7 relativ zu Teil 5 verschoben werden kann. Damit erlaubt die Führung eine Bewegung der Kammern voneinander weg und aneinander vorbei. Die Bewegung wird dabei über die Einrichtung zum Öffnen und Schließen von der mechanischen Steuerkurve 15 vermittelt.

Der in Fig. 2 dargestellte Abschnitt der Steuerkurve ist so geformt, daß bei Bewegung der Transporteinrichtung und damit des mit dieser verbundenen Reaktors in Richtung des Pfeils eine Bewegung des Teils 7 weg vom Teil 5 vermittelt wird, so daß die Reaktorkammer geöffnet wird.

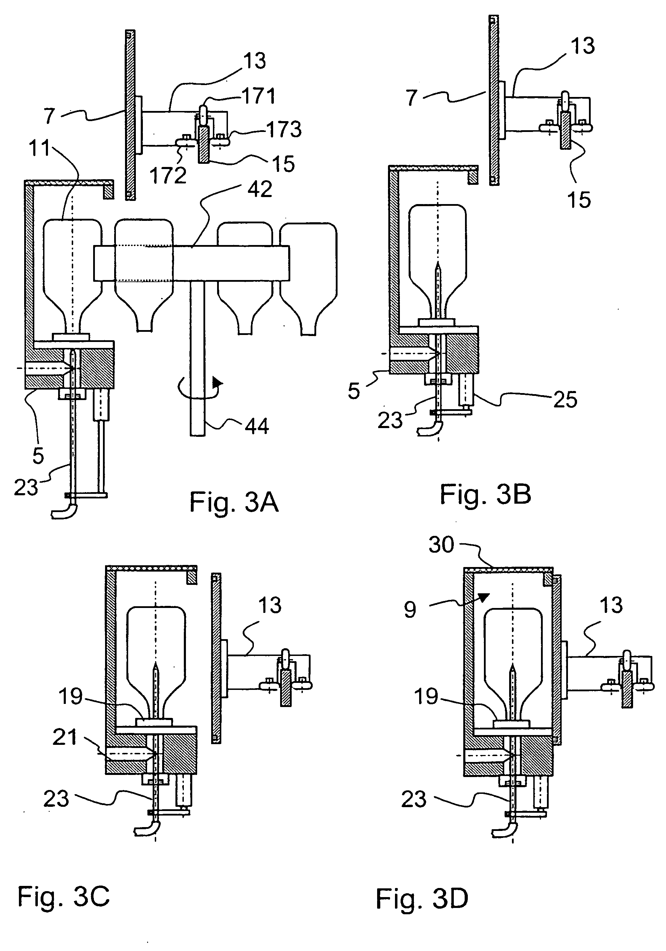

Der Ein- und Ausschleusevorgang von Werkstücken ist genauer anhand der Figuren 3A bis 3D erläutert. In diesem Beispiel wird der Reaktor ebenfalls zur Beschichtung von Kunststoffhohlkörpern, insbesondere von Kunststoffflaschen verwendet. Fig. 3A zeigt eine erste Phase des Einschleusens, bei welcher die Reaktorkammer geöffnet ist und eine Flasche 11 mittels eines Zuteilrades 42, das um eine Achse 44 rotiert wird, in die Kammer befördert wird. Die Flasche 11 wird dann in die Aufnahme 19 eingesetzt. Um die Flasche in die Aufnahme einsetzen zu können, ist während dieses Prozeßabschnitts die Gaslanze 23 aus der Reaktorkammer herausgezogen.

Nach dem Einsetzen der Flasche in die Flaschenaufnahme 19 wird, wie anhand von Fig. 3B gezeigt ist, die Gaslanze in den Innenraum der zu beschichtenden Flasche 11 hineingefahren.

Über die Steuerkurve 15 wird nach dem Einsetzen der Flasche 11 das Teil 7 des Reaktors zunächst entlang des Teils 3 des Reaktors bewegt und vor die Öffnung der Reaktorkammer geschoben, wie anhand von Fig. 3C dargestellt ist.

Schließlich wird, wie in Fig. 3D gezeigt, mittels einer zweiten Bewegung der Steuerkurve 15 der Teil 7 des Reaktors auf den Teil 5 des Reaktors zu bewegt und so die Öffnung der Reaktorkammer 9 geschlossen. Die Kammer und/oder das Flascheninnere werden anschließend über eine an den Kanal 21 angeschlossene Pumpvorrichtung evakuiert. Daraufhin kann das Prozeßgas über die Gaslanze eingelassen werden. Mikrowellen können durch das Fenster 30 in die Kammer eingestrahlt werden, so daß das Prozeßgas ein Plasma bildet und die Reaktionsprodukte die angrenzenden Wände beschichten. In diesem Beispiel wird das Prozeßgas nur in das Flascheninnnere geleitet, so daß es zu einer Innenbeschichtung der Flaschen, beispielsweise als Diffusionsbarriere kommt.

Anschließend an die Beschichtung wird die Flasche wieder ausgeschleust, wozu die oben beschriebenen Schritte in umgekehrter Reihenfolge durchgeführt werden.

## Patentansprüche

1. Vorrichtung zum CVD-Behandeln von Werkstücken, umfassend eine Transporteinrichtung und zumindest einen auf der Transporteinrichtung befestigten Reaktor,
wobei
die Vorrichtung zumindest eine mechanische Steuerkurve und der Reaktor eine Einrichtung zum Öffnen und Schließen aufweisen, welche mit der zumindest einen Steuerkurve betätigt wird, und der Reaktor einen ersten und einen zweiten Teil umfaßt, wobei die Teile eine Reaktorkammer umschließen
**dadurch gekennzeichnet, daß**
die Steuerkurve so angeordnet ist, daß die Einrichtung zum Öffnen und Schließen den zweiten Teil beim Öffnen zunächst in einer ersten Bewegung vom ersten Teil weg und dann in einer zur ersten Bewegung im wesentlichen senkrechten zweiten Bewegung am ersten Teil vorbei bewegt.

2. Vorrichtung nach Anspruch 1, **dadurch gekennzeichnet, daß** die Einrichtung zum Öffnen und Schließen des Reaktors durch Vorbeibewegen des Reaktors an der Steuerkurve betätigt wird.

3. Vorrichtung nach einem der vorstehenden Ansprüche, wobei der erste Teil mit der Transporteinrichtung und der zweite Teil mit der Einrichtung zum Öffnen und Schließen verbunden sind.

4. Vorrichtung nach einem der vorstehenden Ansprüche, **gekennzeichnet durch** eine ebene Dichtfläche zwischen erstem und zweiten Teil.

5. Vorrichtung nach einem der vorstehenden Ansprüche, wobei die Transporteinrichtung eine Rundläufervorrichtung umfaßt.

6. Vorrichtung nach einem der vorstehenden Ansprüche, wobei die Transporteinrichtung eine Langläufervorrichtung umfaßt.

7. Vorrichtung nach einem der vorstehenden Ansprüche, **dadurch gekennzeichnet, daß** die Einrichtung zum Öffnen und Schließen Kurvenrollen umfaßt.

8. Vorrichtung nach einem der vorstehenden Ansprüche, **dadurch gekenzeichnet, daß** der Reaktor ein für elektromagnetische Wellen, insbesondere Mikrowellen transparentes Fenster aufweist.

9. Vorrichtung nach einem der vorstehenden Ansprüche, **dadurch gekennzeichnet, daß** der Reaktor eine Einrichtung zum Evakuieren aufweist.

10. Vorrichtung nach einem der vorstehenden Ansprüche, **gekennzeichnet durch** eine Einrichtung zum Einspeisen eines Prozeßgases.

11. Vorrichtung nach Anspruch 10, wobei die Einrichtung zum Einspeisen eines Prozeßgases eine Gaslanze umfaßt.

12. Vorrichtung nach einem der vorstehenden Ansprüche, **gekennzeichnet durch** zumindest ein Zuteilrad.

13. Verfahren zum CVD-Behandeln von Werkstücken in einem Reaktor, welcher auf einer Transporteinrichtung befestigt ist, und zumindest zwei Teile umfaßt, umfassend die Schritte:
Einfügen des Werkstücks in den Reaktor,
Evakuieren zumindest eines Bereiches der Reaktorkammer,
Einfüllen eines Prozeßgases,
Erzeugen eines Plasmas,
Herausnehmen des Werkstücks,
sowie den Schritt des Öffnens und/oder Schließens des Reaktors mittels einer daran befestigten Einrichtung **durch** Vorbeibewegen an einer mechanischen Steuerkurve,
**dadurch gekennzeichnet, daß**
der Schritt des Schließens und/oder des Öffnens des Reaktors den Schritt des Bewegens der Teile aneinander vorbei und aufeinander zu umfaßt.

14. Verfahren nach Anspruch 13, **dadurch gekennzeichnet, daß** der Schritt des Erzeugens eines Plasmas den Schritt des Einstrahlens von elektromagnetischen Wellen umfaßt.

15. Verfahren nach Anspruch 14, **dadurch gekennzeichnet, daß** der Schritt des Einstrahlens von elektromagnetischen Wellen den Schritt Einstrahlens von gepulsten elektromagnetischen Wellen umfaßt.

16. Verfahren nach Anspruch 14 oder 15, **dadurch gekennzeichnet, daß** der Schritt des Einstrahlens von elektromagnetischen Wellen den Schritt des Einstrahlens von Mikrowellen umfaßt.

17. Verfahren nach einem der Ansprüche 13 bis 16, wobei der Schritt des Einfügens des Werkstücks den Schritt des Einführens des Werkstücks mittels eines Zuteilrades umfaßt.

18. Verfahren nach einem der Ansprüche 13 bis 17, wobei der Schritt des Herausnehmens des Werkstücks den Schritt des Herausführens des Werkstücks mittels eines Zuteilrades umfaßt.

19. Verfahren nach einem der Ansprüche 13 bis 18, wobei das Werkstück einen Hohlkörper umfaßt.

20. Verfahren nach Anspruch 19, **dadurch gekennzeichnet, daß** das Werkstück eine Flasche umfaßt.

21. Verfahren nach Anspruch 19 oder 20, wobei der Schritt des Evakuierens zumindest eines Teils der Reaktorkammer den Schritt des Evakuierens des vom Hohlkörper umschlossenen Volumens umfaßt.

22. Verfahren nach Anspruch 19, 20 oder 21 wobei der Schritt des Einfüllens eines Prozeßgases den Schritt des Einfüllens eines Prozeßgases in das vom Hohlkörper umschlossene Volumen umfaßt.

23. Verfahren nach einem der Ansprüche 19 bis 22, wobei der Schritt des Erzeugens eines Plasmas den Schritt des Erzeugens eines Plasmas in dem vom Hohlkörper umschlossenen Volumen umfaßt.

## Claims

1. CVD apparatus for workpieces, comprising a transport device and at least one reactor fixed on the transport device,
wherein the apparatus comprises at least one mechanical operating cam and the reactor comprises a device for opening and closing which is actuated with the at least one operating cam and the reactor comprises a first and a second part, wherein the parts enclose a reactor chamber,
**characterised in that**
the operating cam is arranged in such a manner that the opening and closing device moves the second part upon opening firstly in a first movement away from the first part and then in a second movement substantially perpendicular to the first movement past the first part.

2. Apparatus according to claim 1, **characterised in that** the device for opening and closing the reactor is actuated by moving the reactor past the operating cam.

3. Apparatus according to one of the preceding claims, wherein the first part is connected to the transport device and the second part is connected to the opening and closing device.

4. Apparatus according to one of the preceding claims, **characterised by** a level sealing surface between the first and second part.

5. Apparatus according to one of the preceding claims, wherein the transport device comprises a rotary running device.

6. Apparatus according to one of the preceding claims, wherein the transport device comprises an elongated running device.

7. Apparatus according to one of the preceding claims, **characterised in that** the opening and closing device comprises cam rollers.

8. Apparatus according to one of the preceding claims, **characterised in that** the reactor comprises a window which is transparent for electromagnetic waves, particularly microwaves.

9. Apparatus according to one of the preceding claims, **characterised in that** the reactor comprises an evacuating device.

10. Apparatus according to one of the preceding claims, **characterised by** a device for introducing a process gas.

11. Apparatus according to claim 10, wherein the device for introducing a process gas comprises a gas lance.

12. Apparatus according to one of the preceding claims, **characterised by** at least one distributing wheel.

13. CVD method for workpieces in a reactor which is fixed on a transport device and comprises at least two parts, comprising the steps:
introduction of a workpiece in the reactor,
evacuation of at least one area of the reactor chamber,
filling with a process gas,
generation of a plasma,
removal of the workpiece
and the step of opening and / or closing the reactor by means of a device fixed thereon by moving past a mechanical operating cam,
**characterised in that**
the step of closing and / or opening the reactor comprises the step of moving the parts past each other and towards each other.

14. Method according to claim 13, **characterised in that** the step of generating a plasma comprises the step of radiation of electromagnetic rays.

15. Method according to claim 14, **characterised in that** the step of radiation of electromagnetic rays comprises the step of radiation of pulsed electromagnetic rays.

16. Method according to claim 14 or 15, **characterised in that** the step of radiation of electromagnetic rays comprises the step of radiation of microwaves.

17. Method according to one of the claims 13 to 16, wherein the step of introducing the workpiece comprises the step of introducing the workpiece by means of a distributing wheel.

18. Method according to one of the claims 13 to 17, wherein the step of removing the workpiece comprises the step of taking out the workpiece by means of a distributing wheel.

19. Method according to one of the claims 13 to 18, wherein the workpiece comprises a hollow body.

20. Method according to claim 19, **characterised in that** the workpiece comprises a bottle.

21. Method according to claim 19 or 20, wherein the step of evacuating at least a part of the reactor chamber comprises the step of evacuating the volume enclosed by the hollow body.

22. Method according to claim 19, 20 or 21, wherein the step of filling with a process gas comprises the step of filling the volume enclosed by the hollow body with a process gas.

23. Method according to one of the claims 19 to 22, wherein the step of generating a plasma comprises the step of generating a plasma in the volume enclosed by the hollow body.

## Revendications

1. Dispositif de traitement en phase vapeur de pièces, comportant un système de transport et au moins un réacteur fixé sur le système de transport,
le dispositif comprenant au moins une came de commande mécanique et le réacteur un système d'ouverture et de fermeture, lequel est actionné par la au moins une came de commande, et le réacteur comportant une première partie et une seconde partie, les parties entourant une chambre de réacteur,
**caractérisé en ce que**
la came de commande est disposée de sorte que le système d'ouverture et de fermeture de la seconde partie, à l'ouverture, s'écarte tout d'abord au cours d'un premier déplacement de la première partie et ensuite, au cours d'un second déplacement sensiblement perpendiculaire au premier déplacement, passe devant la première partie.

2. Dispositif selon la revendication 1, **caractérisé en ce que** le système d'ouverture et de fermeture du réacteur est actionné lorsque le réacteur passe devant la came de commande.

3. Dispositif selon l'une quelconque des revendications précédentes, la première partie étant reliée au système de transport et la seconde partie au système d'ouverture et de fermeture.

4. Dispositif selon l'une quelconque des revendications précédentes, **caractérisé par** une surface d'étanchéité plane entre la première partie et la seconde partie.

5. Dispositif selon l'une quelconque des revendications précédentes, le système de transport comportant un dispositif de déplacement circulaire.

6. Dispositif selon l'une quelconque des revendications précédentes, le système de transport comportant un dispositif de déplacement longitudinal.

7. Dispositif selon l'une quelconque des revendications précédentes, **caractérisé en ce que** le système d'ouverture et de fermeture comporte des galets de came.

8. Dispositif selon l'une quelconque des revendications précédentes, **caractérisé en ce que** le réacteur comprend une fenêtre transparente aux ondes électromagnétiques, notamment aux micro-ondes.

9. Dispositif selon l'une quelconque des revendications précédentes, **caractérisé en ce que** le réacteur comprend un système d'évacuation.

10. Dispositif selon l'une quelconque des revendications précédentes, **caractérisé par** un système d'alimentation en gaz de traitement.

11. Dispositif selon la revendication 10, le système d'alimentation en gaz de traitement comportant une lance à gaz.

12. Dispositif selon l'une quelconque des revendications précédentes, **caractérisé par** au moins une roue de distribution.

13. Procédé de dépôt en phase vapeur de pièces dans un réacteur, lequel est fixé sur un système de transport, et comporte au moins deux parties, comportant les étapes :
d'insertion de la pièce dans le réacteur,
d'évacuation d'au moins une zone de la chambre de réacteur,
de versement d'un gaz de traitement,
de génération d'un plasma,
d'extraction de la pièce,
ainsi que l'étape d'ouverture et/ou de fermeture du réacteur au moyen d'un système fixé dessus passant devant une came de commande mécanique,
**caractérisé en ce que**
l'étape de fermeture et/ou d'ouverture du réacteur comporte l'étape de passage des parties les unes devant les autres et les unes sur les autres.

14. Procédé selon la revendication 13, **caractérisé en ce que** l'étape de génération d'un plasma comporte l'étape d'irradiation d'ondes électromagnétiques.

15. Procédé selon la revendication 14, **caractérisé en ce que** l'étape d'irradiation d'ondes électromagnétiques comporte l'étape d'irradiation d'ondes électromagnétiques pulsées.

16. Procédé selon la revendication 14 ou 15, **caractérisé en ce que** l'étape d'irradiation d'ondes électromagnétiques comporte l'étape d'irradiation de micro-ondes.

17. Procédé selon l'une quelconque des revendications 13 à 16, l'étape d'insertion de la pièce comportant l'étape d'introduction de la pièce au moyen d'une roue de distribution.

18. Procédé selon l'une quelconque des revendications 13 à 17, l'étape d'extraction de la pièce comportant l'étape consistant à faire sortir la pièce au moyen d'une roue de distribution.

19. Procédé selon l'une quelconque des revendications 13 à 18, la pièce comportant un corps creux.

20. Procédé selon la revendication 19, **caractérisé en ce que** la pièce comporte une bouteille.

21. Procédé selon la revendication 19 ou 20, l'étape d'évacuation d'au moins une partie de la chambre de réacteur comportant l'étape d'évacuation du volume entouré par le corps creux.

22. Procédé selon la revendication 19, 20 ou 21, l'étape de versement d'un gaz de traitement comportant l'étape de versement d'un gaz de traitement dans le volume enfermé par le corps creux.

23. Procédé selon l'une quelconque des revendications 19 à 22, l'étape de génération d'un plasma comportant l'étape de génération d'un plasma dans le volume enfermé par le corps creux.
